(19) Europäisches Patentamt
European Patent Office
Office européen des brevets

(11) **EP 4 755 539 A1**

(12) **DEMANDE DE BREVET EUROPEEN**

(43) Date de publication:
**10.06.2026 Bulletin 2026/24**

(21) Numéro de dépôt: **25220920.0**

(22) Date de dépôt: **04.12.2025**

(51) Classification Internationale des Brevets (IPC):
**B09B 3/45** *(2022.01)* **B09B 3/50** *(2022.01)*
**B29B 17/02** *(2006.01)* **B32B 43/00** *(2006.01)*
**C22B 1/00** *(2006.01)* **C22B 7/00** *(2006.01)*
**C22B 11/00** *(2006.01)* **C22B 15/00** *(2006.01)*
**C22B 21/00** *(2006.01)* **H10F 19/80** *(2025.01)*
**H10F 71/00** *(2025.01)* **C22B 3/44** *(2006.01)*
**C22B 3/02** *(2006.01)* **C22B 3/04** *(2006.01)*
**B09B 101/15** *(2022.01)*

(52) Classification Coopérative des Brevets (CPC):
**B09B 3/45; B09B 3/50; B29B 17/02; B32B 43/006;
C22B 1/005; C22B 3/02; C22B 7/006;
C22B 11/046; C22B 15/0002; C22B 15/0004;
C22B 21/0023; H10F 19/80; H10F 71/00;**
B09B 2101/15; C22B 3/04; (Cont.)

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**GE KH LA MA MD TN**

(30) Priorité: **06.12.2024 FR 2413586**

(71) Demandeur: **Commissariat à l'Énergie Atomique
et aux Énergies Alternatives
75015 Paris (FR)**

(72) Inventeurs:
• **LIOTAUD, Lucas
84000 AVIGNON (FR)**
• **BRIAND, Axel
84130 LE PONTET (FR)**
• **RUIZ, Jean-Christophe
30290 LAUDUN L'ARDOISE (FR)**

(74) Mandataire: **Ipsilon
12, Avenue d'Italie
75013 Paris (FR)**

(54) **PROCÉDÉ DE RÉCUPÉRATION DES MÉTAUX PRÉSENTS DANS LES MODULES PHOTOVOLTAÏQUES**

(57) Le procédé comprend les étapes de :
a) fourniture de l'ensemble de multicouches comportant une pluralité d'empilements laminés, chacun des empilements laminés comprenant:
- un support comportant du silicium cristallin,
- des éléments métalliques,
- une première couche d'encapsulation,
- une seconde couche d'encapsulation,

b) application d'un traitement hydrothermal à l'ensemble de multicouches comprenant le placement de la pluralité d'empilements laminés dans une solution aqueuse et l'application d'une chauffe en vue d'amorcer une séparation entre le support et les éléments métalliques,
c) application d'un traitement ultrasonore de sorte à finaliser la séparation entre le support et les éléments métalliques récupérer les éléments métalliques.

[FIG.1]

**(Cont. page suivante)**

EP 4 755 539 A1

(52) Classification Coopérative des Brevets (CPC):
(Cont.)C22B 3/44

# EP 4 755 539 A1

## Description

La présente invention se rapporte au domaine du recyclage de modules photovoltaïques et notamment de la récupération des métaux contenus dans un module. En particulier, l'invention concerne un procédé deux en un permettant de récupérer et de séparer les métaux utilisés dans les modules photovoltaïques en vue de leur recyclage.

A ce jour, la directive européenne 2012/19/EU relative aux Déchets d'Equipement Electriques et Electroniques (DEEE ou *Waste Electrical and Electronic Equipment (WEEE)*) imposent aux industriels un taux de valorisation de 85% massique des matériaux utilisés dans les modules photovoltaïques dont 80% de cette masse doit être réutilisée ou recyclée. Le poids du module reposant principalement sur le poids du verre utilisé (71,9%) les efforts de recyclage ont nettement été portés vers des procédés de délamination de la plaque de verre protégeant la face avant du module. Toutefois, ce verre ne représente que 8% de la valeur économique de l'ensemble de matériaux utilisés. Les métaux et notamment les métaux des cellules photovoltaïques ne représentent qu'une faible part du poids total des panneaux photovoltaïques mais sa part économique peut atteindre 66% du coût des matières premières. Ainsi, et compte tenu de leur raréfaction et des besoins en métaux stratégiques en France et en Europe, il est intéressant de se pencher sur la problématique de trouver une technologie respectueuse de l'environnement qui permettrait la récupération des différents métaux.

Des procédés déjà connus permettent de réaliser la séparation des métaux depuis une ossature de module photovoltaïque ayant subi une étape de désassemblage manuel ou mécanique et une étape de délamination critique du verre par voie thermique, mécanique ou chimique, qui entraine l'élimination et la perte de l'encapsulant plastique. De plus, cette séparation utilise des réactifs puissants et toxiques, nécessitant des solvants organiques et donc des traitements onéreux des effluents toxiques. Ceci impacte lourdement le bénéfice financier du recyclage. Dans le cas d'un procédé de broyage suivi d'une séparation physique, la sélectivité des métaux n'est pas optimale et le verre récupéré est pollué par les différentes poussières d'autres matériaux.

Une méthode particulière de recyclage des modules décrite dans EP3118902 propose un traitement oxydant en conditions subcritiques permettant la séparation du verre du reste du module. Cette méthode préconise l'utilisation d'un réactif oxydant fortement concentré tel que du $HNO_3$ et/ou du $H_2O_2$ entre 30 et 65% en poids à une température comprise entre 130 et 150°C, sur une durée comprise entre 3 et 6 heures et une pression autogène comprise entre 0,5 et 2,5 MPa. Or, ce temps de cycle est très long, les réactifs chimiques sont dangereux et dégradent l'encapsulant qui ne peut pas être retraité.

Une autre méthode décrite dans le document WO2020/240126, utilise un procédé chimique plus doux pour récupérer directement les barres d'Ag présentes sur les cellules en fin de vie ou en provenance des rebus de production. Elle utilise des étapes de gravures en milieu acide et basique avec ou sans application d'ultrasons entre 40 et 100 kHz et notamment des produits chimiques tel que le HF très toxique. Ainsi, la présente invention vise à pallier les inconvénients cités ci-dessus. A cet effet, l'invention propose un procédé de récupération d'au moins un métal présent sur un ensemble de multicouches, l'ensemble de multicouches comprenant notamment des cellules photovoltaïques interconnectées, le procédé de récupération comprenant les étapes suivantes de :

a) fourniture de l'ensemble de multicouches comportant une pluralité d'empilements laminés, chacun des empilements laminés comprenant:

- un support comportant au moins du silicium cristallin,
- des éléments métalliques liés au support, les éléments métalliques étant choisis notamment dans le groupe constitué de cuivre, d'argent et d'aluminium,
- une première couche d'encapsulation laminée sur au moins une face avant du support, et
- une seconde couche d'encapsulation laminée sur au moins une face arrière du support,

b) application d'un traitement hydrothermal à l'ensemble de multicouches comprenant le placement de la pluralité d'empilements laminés dans une solution aqueuse pour former une suspension aqueuse et l'application d'une chauffe en vue de dégrader les première et seconde couches d'encapsulation, de libérer le support et d'amorcer une séparation entre le support et les éléments métalliques,
c) application d'un traitement ultrasonore de sorte à finaliser la séparation entre le support et les éléments métalliques formant une suspension de solides résiduels et récupérer les éléments métalliques.

Les inventeurs ont ainsi mis au point un procédé de séparation des métaux du reste de la structure dans des conditions douces pour obtenir la libération du support des premières et seconde couche d'encapsulation et le décollement des métaux présents sur le support. Ce procédé deux en un est un procédé vert en ce sens qu'il est dépourvu d'utilisation de solvant toxique et dangereux pour l'environnement. Ceci est particulièrement novateur car ces solvants sont habituellement souvent mis en œuvre pour éliminer les polymères des couches d'encapsulation. Le traitement hydrothermal en milieu aqueux, en température et sous pression autogène permet avantageusement la dégradation des polymères et leur solubilisation dans la phase aqueuse, ce qui permet leur valorisation ultérieure, tout en libérant le support. Selon une variante, la pression peut être imposée et contrôlée. Le décollement des éléments métalliques est également amorcé à cette étape, puis le traitement ultrasonore, tout en générant la fragmentation de la pluralité d'empilements laminés, permet de finaliser la séparation entre les éléments métalliques et le support en silicium. Une suspension de solides résiduels comprenant un mélange d'éléments séparables dans l'eau est alors obtenue. Une simple filtration des solides, suivie d'une étape de récupération mécanique tel que le tri granulométrique, ou le tri densimétrique permet la séparation des fragments de silicium et des métaux entre eux. Ceci facilite leur purification ultérieure et limite au maximum l'utilisation de solution acide classiquement utilisée pour la séparation des métaux.

Par le terme 'chauffe' on entend dans le présent document une « montée en température » dans le réacteur. Celle-ci peut être douce et l'on parle de conditions subcritiques avec une pression autogène à minima. Celle-ci peut être plus importante avec une pression également plus importante et génère des conditions supercritiques. Toutefois, cette chauffe est bien différente de celle d'un traitement thermique de délamination, par pyrolyse ou par incinération. Bien entendu, les conditions subcritiques offrent une économie d'énergie très importante par comparaison avec un traitement de pyrolyse mais les conditions supercritiques, même si elles sont plus drastiques, restent une option plus économique à celle de la pyrolyse.

Selon une disposition, le traitement hydrothermal de l'étape b) est réalisé dans un autoclave de traitement hydrothermal étanche pour obtenir une pression autogène et atteindre des conditions subcritiques ou supercritiques.

La pression autogène est déterminée par la température et le volume d'eau introduit dans l'autoclave.

Selon une possibilité, la pression est contrôlée au moyen d'équipements de régulation mécanique.

Selon une disposition, l'étape c) est réalisée de façon concomitante à l'étape b), par exemple l'étape c) est réalisée au cours du refroidissement de la suspension aqueuse formée à l'étape b).

Selon une variante de réalisation, l'étape c) est réalisée en même temps que le refroidissement de la suspension aqueuse formée à l'étape b).

Selon une possibilité, l'étape c) est réalisée après l'étape b), notamment la suspension aqueuse obtenue à l'issue de l'étape b) est déplacée dans un dispositif à ultrason annexe afin de réaliser l'étape c).

Selon une disposition, le procédé comprend en outre une étape d) réalisée après l'étape c) comprenant une filtration et un séchage des solides résiduels, en vue de la réalisation d'un procédé de séparation physique des solides résiduels, tel qu'un tri granulométrique ou un tri densimétrique.

Selon une possibilité, le traitement hydrothermal selon l'étape b) et/ou le traitement ultrasonore selon l'étape c) est répété plusieurs fois, notamment répété une fois dans des conditions indépendantes des conditions initiales.

Selon une disposition, le traitement hydrothermal selon l'étape b) comprend en outre l'addition d'un agent oxydant dans la suspension aqueuse, notamment d'une solution de peroxyde d'hydrogène $H_2O_2$, de sorte à obtenir une concentration massique comprise entre 0 et 20% en poids de $H_2O_2$ dans la solution aqueuse, de préférence entre 0,1% et 17% en poids, et en particulier entre 1 et 15% en poids dans la solution aqueuse.

Selon une possibilité, la concentration des empilements laminés à l'étape b) est comprise entre 1g de solide résiduel pour 30g de solution aqueuse et 1 g de solide résiduel pour 5 g de solution aqueuse, et par exemple une concentration de 1g de solide résiduel pour 18g de solution aqueuse, 1g de solide résiduel pour 20g de solution aqueuse, voire 1g de solide résiduel pour 23g de solution aqueuse.

Selon une disposition, le traitement hydrothermal selon l'étape b) est réalisé par application d'une chauffe comprise entre 50°C et 400°C pendant 30 min à 4h, de préférence par application d'une chauffe comprise entre 150 et 250°C pendant 1h30 et 2h30 de sorte à atteindre une pression autogène d'environ 20 bars (conditions subcritiques) ou par application d'une chauffe entre 350°C et 420°C pendant 1h30 à 2h30 de sorte à atteindre une pression autogène d'environ 290 bars (condition supercritiques).

Selon une possibilité, le traitement ultrasonore selon l'étape c) comprend l'application d'ondes de fréquence comprise entre 20 et 80 kHz, par exemple entre 30 et 40 kHz et en particulier à 37 kHz, notamment à pression atmosphérique, et en particulier sur une durée comprise entre 15 min et 70 min, par exemple entre 20 et 60 min.

Selon une disposition, le procédé comprend avant l'étape a) une étape i) comprenant une délamination d'une éventuelle plaque de verre laminée sur la face avant de l'ensemble de multicouches et/ou d'une éventuelle feuille de matériau plastique sur la face arrière (ou backsheet), notamment lorsque l'ensemble de multicouches comprend des cellules photovoltaïques.

Selon un mode de réalisation particulier de l'étape i), la délamination est réalisée selon le mode opératoire décrit dans le document WO2020/104754.

Selon une disposition, le matériau de la première couche d'encapsulation et le matériau de la seconde couche d'encapsulation sont choisis indépendamment l'un de l'autre parmi les polymères et notamment dans le groupe constitué de poly(éthylène-co-acétate de vinyle) (ou EVA), de polyoléfine élastomère (POE), de ionomère, de poly(butyral de vinyle) (PVB), de poly(diméthylsiloxane) (PDMS) et de polyuréthane thermoplastique (TPU). Ces polymères sont avantageusement capables de se dégrader partiellement voire totalement dans des conditions hydrothermales, c'est-à-dire dans l'eau portée à haute température et haute pression (conditions subcritriques ou supercritriques) avec ou en l'absence d'oxydant.

Selon une possibilité, la pluralité d'empilements laminés est soumise à une étape de réduction des dimensions avant l'application du traitement hydrothermal selon l'étape b). Cela peut être utile selon le volume du réacteur hydrothermal utilisé. Lorsque les empilements laminés ne sont pas réduits en taille, le traitement hydrothermal peut nécessiter une durée plus longue.

Selon d'autres caractéristiques, le procédé de récupération de l'invention comporte une ou plusieurs des caractéristiques optionnelles suivantes considérées seules ou en combinaison :

- L'autoclave de traitement hydrothermal est un réacteur étanche dimensionné pour résister à de hautes températures et de hautes pressions.
- La pluralité d'empilements laminés comprend des cellules photovoltaïques.
- Les cellules photovoltaïques sont interconnectées ou non.
- La cellule photovoltaïque est choisie parmi le groupe constitué de cellules de type Al-BSF (acronyme anglophone de *Aluminum Back Surface Field*), PERC (*Passivated Emitter and Rear Contact*), PERL (*Passivated Emitter with Rear Locally diffused*), PERT (*Passivated Emitter with Rear Totally diffused*), TOPCon (*Tunnel Oxyde Passivated Contact*), IBC (*Interdigitated Back Contact*) et des cellules à hétérojonction.
- Le procédé est appliqué à un mélange de différents types de cellule photovoltaïques en même temps.
- Les cellules photovoltaïques peuvent être des rebus de fabrication, avec ou sans interconnexions, ou se trouver comprise dans l'empilement laminé.
- Le support comprend au moins une plaquette de silicium, dopé n, dopé p ou intrinsèquement non dopé.
- Une plaquette de silicium est une couche autoportée de silicium présentant une épaisseur d'au moins 100 micromètres.
- Le support comprend en outre une pluralité de couches solidaires de la plaquette de silicium, notamment des couches de passivation, de couches antireflets, des couches émettrices, des jonctions tunnel, par exemple en nitrure de silicium, oxyde de silicium, en $Al_2O_3$, des couches TCO (Transparent Conductive Oxide) ».
- Le support est majoritairement constitué de silicium cristallin.
- Le silicium est monocristallin
- Le silicium est polycristallin.
- La première couche d'encapsulation recouvre la totalité de la face avant du support.
- La seconde couche d'encapsulation recouvre la totalité de la face arrière du support.
- La face avant du suppport est la face destinée à recevoir les rayonnements du soleil.
- La face arrière du suppport est la face opposée à la face avant.
- Les éléments métalliques sont destinés à la conduction du courant électrique.
- Les éléments métalliques comprennent des collecteurs de courant électriques sur la face avant et/ou arrière du support, notamment des collecteurs de courant en Ag et Al, et des barrettes d'interconnections en Cu ou Cu/Ag reliant les cellules photovoltaïques entre elles.
- La suspension aqueuse obtenue à l'issue de l'étape b) est filtrée et les solides récupérés sont lavés, puis séchés en étuve à 50°C, puis les solides sont remis en suspension dans l'eau avant de réaliser l'étape c).
- Le traitement ultrasonore de l'étape c) est réalisé in situ, i.e. directement dans l'autoclave accueillant un dispositif de sonotrode, de sorte à limiter les étapes intermédiaires ou de transferts.
- Les conditions initiales sont les conditions de réalisation du premier traitement hydrothermal selon l'étape b) du procédé et/ou ultrasonore selon l'étape c) du procédé.
- Le traitement ultrasonore selon l'étape c) est réalisée sur une plage de température comprise entre 20 et 50°C.

D'autres aspects, buts et avantages de la présente invention apparaîtront mieux à la lecture de la description suivante d'un mode de réalisation de celle-ci, donnée à titre d'exemple non limitatif et faite en référence aux figures suivantes :

[Fig. 1] est une vue schématique représentant un empilement laminé provenant d'un panneau photovoltaïque à base de Si de type Al-BSF selon un mode de réalisation de l'invention.

[Fig. 2] est une vue illustrant une photo des fragments de cellules de type PERC selon l'invention et des clichés MEB illustrant les éléments métalliques sur le support en Si.

[Fig. 3] est une vue illustrant des photos de fragments d'empilement et un cliché MEB illustrant les éléments métalliques séparés du support en Si selon un mode de réalisation de l'invention.

[Fig. 4] est une vue d'un cliché MEB illustrant la surface avant du support de silicium après application du traitement hydrothermal selon un mode de réalisation de l'invention.

[Fig. 5] est une vue d'un cliché MEB illustrant la surface arrière du support de silicium après application du traitement hydrothermal selon un mode de réalisation de l'invention.

[Fig. 6] est une vue d'un cliché MEB illustrant la surface avant du support de silicium après application du procédé selon un mode de réalisation de l'invention.

[Fig. 7] est une vue d'un cliché MEB illustrant la surface arrière du support de silicium après l'application du procédé selon un mode de réalisation de l'invention.

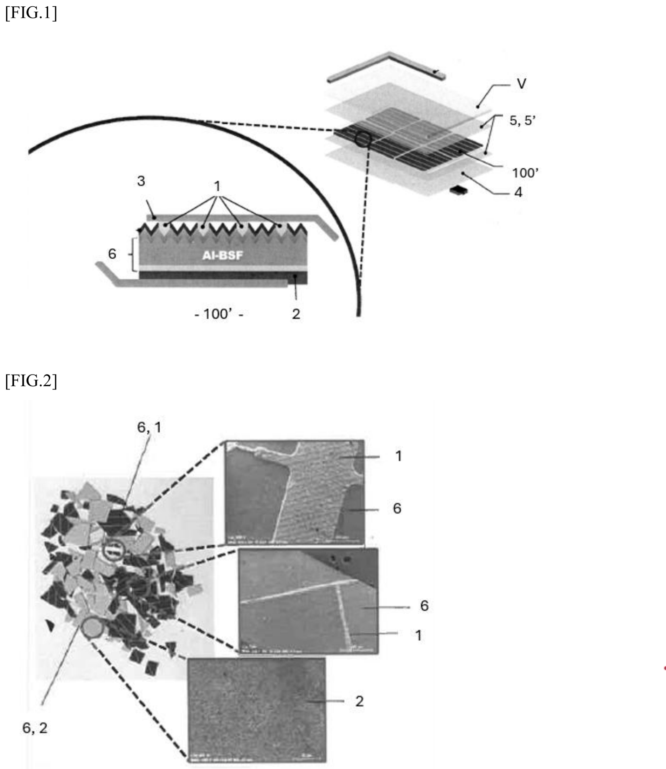

Les inventeurs ont tout d'abord mis en œuvre le procédé de récupération de métaux (collecteurs en face avant 1 en Ag, collecteurs en face arrière en Al 2, interconnexions 3 en Cu ) présents sur un ensemble de multicouches 100, en particulier une cellule photovoltaïque à base de silicium cristallin ne contenant aucune couche d'encapsulation 5 (figure 1). Ce type de cellule 100' provient par exemple de rebus de fabrication ou d'un ensemble de multicouches 100' dont la plaque de verre V, le backsheet 4 et les couches d'encapsulation 5 ont été retirés au préalable.

En particulier, les inventeurs ont considéré des cellules photovoltaïques 100' de type PERC sans verre, backsheet 4 ou couche d'encapsulation 5 comme illustré sur la figure 1. Des fragments de la cellule photovoltaïques 100' avant traitement sont illustrés sur la figure 2 pour servir de témoin. Les régions agrandies sur les clichés MEB illustrent bien les collecteurs 1 en Ag sur la face avant du support 6 en Si ainsi que le collecteur 2 en Al sur la face arrière (ressemble à une zone frittée).

Le mode opératoire suivi comprend les étapes suivantes :
0.5 g de cellule photovoltaïque 100' est introduit dans un autoclave de 45 mL (Parr, no. 4744) (étape a) avec une solution de peroxyde d'hydrogène ($H_2O_2$) de concentration massique qui a été variée entre 0 et 15 % en poids (étape b) selon les expériences. Celles-ci ont été réalisées avec un rapport massique de solution aqueuse variant entre 1g cellule / 9 g de solution à 1g cellule / 26 g de solution.

L'autoclave est placé dans un four pour un traitement dans des conditions douces subcritiques, à savoir une température opératoire de 200 ou 230°C pendant 2 heures (la pression est autogène et déterminée par la quantité d'eau dans l'autoclave). En fin d'expérimentation, le tout est refroidi jusqu'à la température ambiante et la suspension aqueuse (i.e. cellules photovoltaïques 100' traitées et solution aqueuse) est transférée dans un dispositif à ultrason qui est refermé avant d'être soumis à un traitement ultrasonore à environ 37kHz (étape c) pendant environ 60 min.

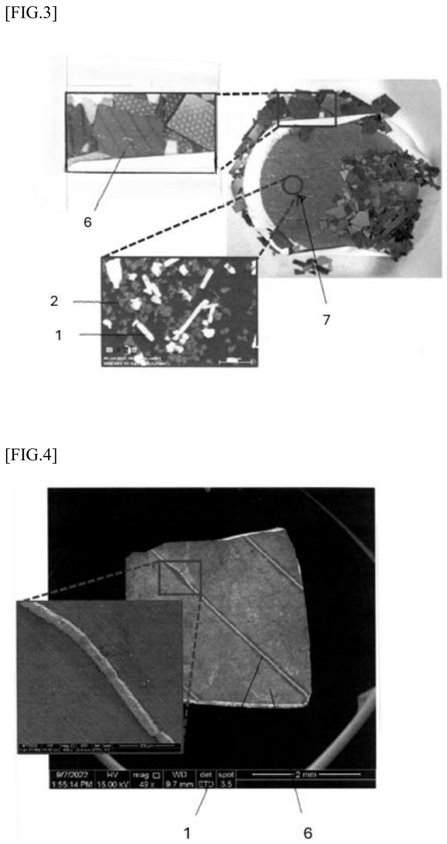

A la fin du traitement ultrasonore (US), la suspension est filtrée sur un filtre en PTFE présentant une taille de pore de 0,45 $\mu$m et les solides récupérés sont séchés en étuve à 50°C (figure 3). Les fragments de cellules 100' séparés sont ensuite tamisés à 500$\mu$m de manière à obtenir d'une part une fraction riche en silicium (particules environ > 500$\mu$m) et d'autre part une fraction riche en argent et en aluminium (particules environ < 500$\mu$m). En effet, l'observation de l'ensemble des fragments de cellules 100' obtenu après le traitement ultrasonore, permet de distinguer très facilement que les fragments de support 6 en silicium sont assez gros (fractions > 500 $\mu$m) et que les particules 7 d'argent et d'aluminium sont bien plus petites (fractions < 500 $\mu$m). Le tamisage à 500 $\mu$m est alors choisi dans le but d'obtenir deux type de fractions métalliques : la première riche en Silicium, soit celle de taille supérieure à 500 $\mu$m ; et la seconde riche en argent et aluminium, soit celle inférieure à 500 $\mu$m (cliché MEB de la figure 3 ). Ce choix est totalement arbitraire est sert principalement aux besoins analytiques.

Des analyses chimiques par ICP-AES permettent de quantifier les métaux dans chaque fraction.

Les résultats de récupération de métaux 1,2 séparés sont consignés dans le tableau 1 ci-dessous. Le pourcentage de décollement des éléments métalliques (Ag et Al) vis-à-vis du support (Si) est calculé avec la formule (I) qui suit :
[Math 1]

$$E_{décollement} \, (en \, \%) = \frac{masse \; cellule \; initiale \; - \; masse \; cellule > 500\mu m}{masse \; cellule \; initiale} \times 100 \tag{I}$$

A titre de comparaison, des essais complémentaires ont été réalisés sur des fragments de cellules 100' non traités par le traitement hydrothermal (HT) et ayant uniquement subi le traitement ultrasonore (US), de sorte à servir de témoin de référence (entrée 1) pour évaluer l'efficacité du traitement hydrothermal.

[Tab 1]

| entrée | HT (°C) | US (kHz) | Concentration cellule en g / solution en g | Concentration massique en $H_2O_2$ | | | | |
|---|---|---|---|---|---|---|---|---|
| | | | | 0% | 1% | 5% | 10% | 15% |
| 1 | -na- | 37 | 1 / 26 | 4,0 | 3,2 | 1,3 | 1,8 | **3,8** |
| 2 | 200 | 37 | 1 / 9 | 2,9 | 7,2 | 7,2 | 7,0 | **7,1** |
| 3 | 200 | 37 | 1 / 18 | **7,3** | 7,9 | 7,1 | 7,1 | 7,4 |

(suite)

| entrée | HT (°C) | US (kHz) | Concentration cellule en g / solution en g | Concentration massique en $H_2O_2$ | | | | |
|--------|---------|----------|---------------------------------------------|------|------|------|------|------|
| | | | | 0% | 1% | 5% | 10% | 15% |
| 4 | 200 | 37 | 1 / 26 | 7,5 | 6,8 | 7,1 | 7,4 | 7,0 |
| 5 | **230** | 37 | 1 / 26 | 8,1 | 6,9 | 7,5 | 7,6 | 7,0 |

*Tableau 1 : Décollement des métaux de la cellule (en %) - Décollement théorique max de 7,8%. Si le décollement mesuré est supérieur à la théorie, il est possible que cela vienne d'un biais d'échantillonnage.*

L'entrée 1 de ce tableau 1 montre l'importance de la réalisation du traitement hydrothermal avant l'application du traitement par US. En effet sans traitement HT, le pourcentage de décollement observé est limité à 4% alors qu'en présence du traitement HT (en condition subcritiques - pression comprise entre 15 et 50 bars), il est possible d'obtenir un décollement de la totalité des métaux 1,2. On peut par ailleurs noter que plus la concentration massique de solide dans la solution est faible (dilution importante), plus les résultats de décollement sont bons. Ceci peut être contrebalancé par la présence de l'agent oxydant $H_2O_2$ qui, dès 1%, conduit à des résultats similaires pour une dilution deux fois moins importante (se reporter aux entrées 2 et 3, même décollement obtenu pour une concentration 1 :9 avec 1% poids de $H_2O_2$ au lieu d'une concentration de 1 :18 sans $H_2O_2$).

Ainsi, la réalisation du traitement hydrothermal avant les ultrasons favorise grandement le décollement des collecteurs 1 en argent (face avant) et en aluminium 2 (face arrière) du support 6 en silicium. Les variations de la concentration massique en $H_2O_2$, du ratio massique cellule : solution et de la température impactent peu le décollement.

Ceci est corroboré par les figures 2 et 3 illustrant des photos et des clichés MEB respectivement avant réalisation du procédé de l'invention et après réalisation du procédé complet. Avant traitement, on peut observer sur les débris d'une cellule PERC les collecteurs 1 en argent en face avant et les collecteurs 2 en aluminium en face arrière. Après mise en œuvre des deux traitements, les débris de la cellule montrent l'absence des collecteurs 1,2 d'argent et d'aluminium. Le cliché MEB montre d'ailleurs un grossissement de la fraction de solide riche en Ag et Al (taille inférieure à 500 micromètres) où l'on peut distinguer les résidus de barres d'argent (couleur très claire) et les éléments en Al (couleur plus foncée).

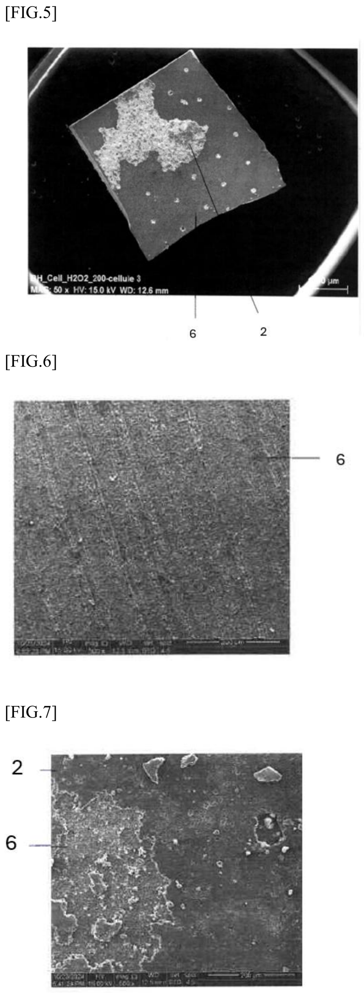

Par ailleurs, l'importance du traitement par US est bien mise en évidence par les clichés MEB des figures 4 et 5 qui illustrent le décollement partiel des collecteurs 1,2 après traitement HT et avant traitement US. Sur la figure 4, le cliché montre l'amorce du décollement des collecteurs 1 d'Ag sur la face avant du support 6. Sur la figure 5, le cliché montre le décollement de la plus grande partie des collecteurs 2 en aluminium sur la face arrière du support 6. Ainsi, le traitement US est bien utile pour finaliser les décollements des métaux 1,2 observés dans les résidus solides (figure 3).

Après le traitement hydrothermal et ultrasonore, les particules 7 métalliques sont séparées grossièrement par un tamisage à 500 micromètres dans le but d'obtenir une fraction riche en silicium et une autre fraction riche en aluminium et en argent. Chaque fraction est ensuite dissoute entièrement et caractérisée chimiquement. Il en ressort alors que la pureté du silicium de la fraction riche en silicium est dans certains cas supérieure à 99% (silicium de grade métallurgique), dans le cas d'utilisation de l'eau seule. L'ajout d'oxydant, comme le $H_2O_2$, dans des concentrations relativement faible, inférieure à 15% massique, permet d'obtenir des puretés similaires voire supérieures et cela avec des concentrations en cellules plus importantes.

L'analyse chimique de la fraction riche en argent et aluminium (inférieure à 500 micromètres) montre que l'utilisation d'eau dans certaines conditions opératoires, à savoir une température de 230°C et une ratio massique cellules : eau de 1g : 26g, permet de récupérer sous forme solide la totalité de l'aluminium et plus de 90% de la masse d'argent, contenus dans la cellule photovoltaïque 100'. L'ajout d'un oxydant, comme le $H_2O_2$ dans des concentrations massiques dans l'eau comprises entre 1 et 15% en poids, permet de réduire la température opératoire du traitement hydrothermal et d'augmenter la concentration en cellules photovoltaïques 100' dans l'eau.

Les inventeurs ont ensuite déterminé les conditions optimales pour dégrader le matériau le plus couramment utilisé pour former les couches d'encapsulation 5, dans les modules photovoltaïques, à savoir l'EVA. Il peut être présent sous la forme d'une couche pleine sur le support 6 de la cellule ou sous forme moussée, lorsque par exemple la délamination préalable de la plaque verre V du module photovoltaïque est réalisée par réaction avec du $CO_2$ dans des conditions supercritiques. Un descriptif complet de la réaction avec du $CO_2$ est décrit dans le document WO2020/104754. Les inventeurs ont évalué la dégradation de ces deux types d'EVA moussé par du $CO_2$ et non moussé.

Les exemples de mise en œuvre de la dégradation de l'EVA non moussé par le traitement hydrothermal de l'étape b) sont réalisés comme suit :

Une feuille d'EVA (Lushan EV1050G1/RF) est préalablement laminée entre deux plaques de téflon afin d'activer les agents de réticulation puis coupée en morceaux d'environ 1 à 2 cm de côté. 0,2 g d'EVA ( surface moyenne de 1,18 cm2) sont ensuite placé dans un autoclave de 45 mL (Parr, no. 4744). Un mélange d'eau et de peroxyde d'hydrogène ($H_2O_2$) présentant une concentration massique en $H_2O_2$ comprise entre 0 et 15% en poids est ajouté à l'échantillon selon un rapport massique EVA : solution de 1g : 23 g. L'autoclave est ensuite placé dans un four et chauffé à une température comprise entre 180 et 220°C, préférentiellement 200°C, pendant 2 à 4 heures, préférentiellement 2 heures. La pression dans l'autoclave est autogène. Les essais sont réalisés en triplicat. Le pourcentage de dégradation est défini selon la formule (II) suivante :

[Math 2]

$$E_{deg}(en\ \%) = \frac{masse\ initiale\ -\ masse\ finale}{masse\ initiale} \times 100 \qquad (II)$$

Le tableau 2 ci-dessous consigne les résultats obtenus selon les conditions de traitement.

[Tab 2]

|  |  |  | Concentration massique en $H_2O_2$ | | | | |
|---|---|---|---|---|---|---|---|
| Entrée | HT (°C) | Durée en heure | 0% | 1% | 5% | 10% | 15% |
| 1 | **180** | 2 | 1.40 | 5.59 | 15.07 | 13.52 | 14.19 |
| 2 | 200 | 2 | 4,24 | 14,82 | 57,01 | 80,43 | **83,53** |
| 3 | **220** | 2 | 4,63 | 14,44 | 53,40 | 62,89 | 74,74 |
| 4 | 200 | **4** | 4,22 | 13,53 | 50,55 | 69,68 | 78,83 |
| 5* | 200 | 2 |  |  | 39,8 | 63,1 | **79,6** |

*Tableau 2 : Dégradation de l'EVA par traitement HT. * EVA moussé par traitement $CO_2$*

Le meilleur résultat est obtenu avec un traitement HT à 200°C, pendant 2h en présence de 15% en poids d'oxydant $H_2O_2$ (entrée 2). L'entrée 5 illustre les résultats du test réalisé sur un échantillon d'EVA ayant subi une étape préalable de moussage dans des conditions identiques à celle permettant la délamination de la plaque de verre V du module photovoltaïque. L'échantillon considéré comprend une couche pleine d'EVA laminée entre deux plaques de téflon puis moussée par un traitement au $CO_2$ dans des conditions supercritiques (130 bar, 75°C, 30 min). Le traitement HT appliqué est identique à celui appliqué à l'EVA non moussé. En conclusion, les résultats de dégradation d'EVA moussé sont similaires à ceux obtenus à partir d'EVA non moussé.

La phase liquide récupérée en fin de traitement HT est analysée par chromatographie afin de vérifier la dégradation de l'EVA. Les analyses par GC-MS de la phase liquide montrent, dans un premier temps, la déacétylation du motif acétate de vinyle dont le produit est l'acide acétique (a) puis la scission du squelette carboné résiduel d'éthylène en acides carboxyliques, cétones, lactones, etc...

Les inventeurs ont ensuite mis en œuvre le procédé de l'invention sur un ensemble de multicouches 100. Pour ce faire, ils ont considéré un sandwich EVA/cellule 100'/EVA, ayant préalablement subi une étape de délamination par du CO2 en conditions supercritiques (75°C, 2 cycles, 130 bars/30 min, 150 bars/10 min) afin de retirer la plaque de verre V et le backsheet 4 du module et qui a conduit au moussage de l'EVA. L'EVA utilisé est du Lushan EV1050G1/RF ® et les cellules 100' sont de type PERC, non interconnectées.

Environ 10g de ce sandwich sont insérés dans un autoclave de 600mL. Puis 180mL d'une solution eau: $H_2O_2$ de composition 85:15 en poids y est ajoutée. L'autoclave est ensuite refermé et mis en chauffe à une consigne de 200°C (pression autogène d'environ 50 bar) pendant 4 heures (sans compter une montée en température de 30 minutes et un refroidissement de 30 minutes à l'air comprimé jusqu'à température ambiante). Un premier panier perforé avec, au fond, un filtre en acier inoxydable (maille REPS, 25$\mu$m) sert de réceptacle des sous-produits de l'hydrolyse de l'EVA. Les échantillons à traiter sont disposés dans un second panier perforé, posé au-dessus du premier, avec un filtre en acier inoxydable (maille carrée, 220$\mu$m) permettant la collecte des fragments de cellules photovoltaïques 100' libérées lors du traitement HT. Une fois traité, le solide et le liquide sont séparés. L'échantillon solide résiduel (i.e. cellule, EVA résiduel et sous-produits) est séché puis séparé de façon à récupérer la fraction de cellule libérée, elle-même rincée et à nouveau séchée en étuve à 50°C. Cette dernière est disposée dans un flacon sous eau, puis placée dans un bain à ultrasons (37kHz) pendant 1 heure. Une séparation solide-liquide est réalisée par filtration sur du PTFE 0,45 micromètre et le solide résiduel est séché en étuve à 50°C.

Les analyses effectuées montrent que 31,1% d'EVA a été dégradé et que la cellule a été libérée à 2,2%. Les formules III et IV suivantes ont été utilisées respectivement pour effectuer ces calculs :

[Math 3]

$$E_{deg}(en \%) = \frac{Masse\ sandwich\ initiale\ -\ masse\ sandwich\ finale}{masse\ d'EVA\ dans\ le\ sandwich} \times 100 \qquad (III)$$

[Math 4]

$$E_{lib}(en \%) = \frac{Masse\ de\ cellule\ libérée}{masse\ initiale\ de\ cellule\ dans\ le\ sandwich} \times 100 \qquad (IV)$$

A la vue de ce résultat, le procédé de l'invention a été remis en œuvre dans des conditions supercritiques. Environ 10g du sandwich traité au $CO_2$ dans les mêmes conditions que précédemment sont placés dans un autoclave fermé (étanche) et mis en chauffe à 400°C (pression autogène de 288 bars) pendant 2 heures (sans compter une montée en température de 80 minutes et un refroidissement de 30 minutes à l'air comprimé jusqu'à température ambiante). Un premier panier perforé avec, au fond, un filtre en acier inoxydable (maille REPS, 25μm) sert de réceptacle aux sous-produits de l'hydrolyse de l'EVA. Les échantillons à traiter sont disposés dans un second panier perforé, posé au-dessus du premier, avec un filtre en acier inoxydable (maille carrée, 220μm) permettant la collecte des fragments de cellules photovoltaïques 100' libérées lors du traitement. Une fois traité, le solide et le liquide sont récupérés séparément. On observe le décollement total des collecteurs 1 en Ag dont les particules 7 ont été dissoutes dans la suspension aqueuse (figure 6). L'Ag a ensuite précipité sur les parois du réacteur au cours du refroidissement et il est possible de le récupérer par un traitement acide, par exemple par ajout d'acide nitrique. L'échantillon solide résiduel (i.e. cellule, EVA résiduel et sous-produits de dégradation) est séché puis séparé de façon à récupérer la fraction de cellule 100' libérée, elle-même rincée et à nouveau séchée en étuve à 50°C. Cette dernière est disposée dans un flacon sous eau, puis placée dans un bain à ultrasons (37kHz) pendant 1 heure. La suspension est filtrée puis séchée dans une étuve à 50°C avant tamisage à 500μm. Les analyses montrent que 49,1% de l'EVA a été dégradé et que la cellule a été libérée à 100% par le traitement HT en conditions supercritiques. Le traitement US a permis de décoller partiellement les collecteurs 2 en aluminium (se rapporter à la figure 7). Un second traitement US renouvelé sur le support 6 comportant l'aluminium permet de finaliser la séparation des collecteurs d'aluminium 2.

Selon une disposition non illustrée, il est possible de renouveler la totalité du procédé (traitements des étapes b et c) dans les mêmes conditions que précédemment ou dans des conditions plus douces afin de séparer la totalité des éléments métalliques 1,2.

Selon une autre possibilité non représentée, l'invention est mise en œuvre en présence des interconnecteurs 3 en cuivre sur les cellules 100'. Les interconnexions 3 ou barrettes en cuivre étant simplement soudées aux collecteurs 1,2 avant et arrière, les interconnexions 3 restent solidaires des collecteurs 1,2 lors de la séparation de ces collecteurs 1,2 du support 6 ou peuvent être séparées des collecteurs 1,2. Ainsi les interconnexions 3 en cuivre sont récupérées dans la suspension séparable. Elles sont ensuite isolées lors des procédés de séparation physique des solides résiduels.

Ainsi la présente invention permet d'obtenir la délamination des couches d'encapsulation 5 et le décollement de métaux 1,2,3 de cellules photovoltaïques 100' sans utilisation de solvant et avec un impact environnemental et un cout énergétique plus faibles que pour les procédés utilisés à ce jour. Le procédé permet de récupérer les métaux 1,2, notamment par voie solide, en suspension dans l'eau, ce qui facilite leur séparation et leur purification tout en limitant au maximum l'utilisation conventionnelle de réactifs acides. Par ailleurs, l'étape b) de traitement HT peut être réalisé en mode batch ou en mode semi-dynamique avec décorrélation de la température et de la pression, ce qui offre une modularité intéressante pour une intégration dans des procédés industriels.

**Revendications**

1. Procédé de récupération d'au moins un métal présent sur un ensemble de multicouches (100), l'ensemble de multicouches (100) comprenant notamment des cellules photovoltaïques (100') interconnectées, le procédé de récupération comprenant les étapes suivantes de :

   a) fourniture de l'ensemble de multicouches (100) comportant une pluralité d'empilements laminés, chacun des empilements laminés comprenant:

   - un support (6) comportant au moins du silicium cristallin,
   - des éléments métalliques (1,2 3) liés au support (6), les éléments métalliques (1,2,3) étant choisis notamment dans le groupe constitué de cuivre, d'argent et d'aluminium,
   - une première couche d'encapsulation (5) laminée sur au moins une face avant du support (6), et

- une seconde couche d'encapsulation (5') laminée sur au moins une face arrière du support (6),

b) application d'un traitement hydrothermal à l'ensemble de multicouches (100) comprenant le placement de la pluralité d'empilements laminés (100') dans une solution aqueuse pour former une suspension aqueuse et l'application d'une chauffe en vue de dégrader les première et seconde couches d'encapsulation (5,5'), de libérer le support (6) et d'amorcer une séparation entre le support (6) et les éléments métalliques (1,2,3), le traitement hydrothermal étant réalisé dans un autoclave de traitement hydrothermal étanche pour obtenir une pression autogène et atteindre des conditions subcritiques ou supercritiques,

c) application d'un traitement ultrasonore de sorte à finaliser la séparation entre le support (6) et les éléments métalliques (1,2,3), formant une suspension de solides résiduels et récupérer les éléments métalliques (1,2,3).

2. Procédé de récupération d'au moins un métal selon la revendication 1, dans lequel l'étape c) est réalisée de façon concomitante à l'étape b), par exemple l'étape c) est réalisée au cours du refroidissement de la suspension aqueuse formée à l'étape b).

3. Procédé de récupération d'au moins un métal selon la revendication 1, dans lequel l'étape c) est réalisée après l'étape b), notamment la suspension aqueuse obtenue à l'issue de l'étape b) est déplacée dans un dispositif à ultrason annexe afin de réaliser l'étape c).

4. Procédé de récupération d'au moins un métal selon l'une des revendications 1 à 3, lequel comprend une étape d) réalisée après l'étape c) comprenant une filtration et un séchage des solides résiduels, en vue de la réalisation d'un procédé de séparation physique des solides résiduels, tel qu'un tri granulométrique ou un tri densimétrique.

5. Procédé de récupération d'au moins un métal selon l'une des revendications 1 à 4, dans lequel le traitement hydrothermal selon l'étape b) et/ou le traitement ultrasonore selon l'étape c) est répété plusieurs fois, notamment répété une fois dans des conditions indépendantes des conditions initiales.

6. Procédé de récupération d'au moins un métal selon l'une des revendications 1 à 4, dans lequel le traitement hydrothermal selon l'étape b) comprend en outre l'addition d'un agent oxydant dans la suspension aqueuse, notamment d'une solution de peroxyde d'hydrogène $H_2O_2$, de sorte à obtenir une concentration massique comprise entre 0 et 20% en poids de $H_2O_2$ dans la solution aqueuse, de préférence entre 0,1% et 17% en poids, et en particulier entre 1 et 15% en poids dans la solution aqueuse.

7. Procédé de récupération d'au moins un métal selon l'une des revendications 1 à 6, dans lequel la concentration des empilements laminés à l'étape b) est comprise entre 1g de solide résiduel pour 26g de solution aqueuse et 1 g de solide résiduel pour 9 g de solution aqueuse, et par exemple une concentration de 1g de solide résiduel pour 18g de solution aqueuse, 1g de solide résiduel pour 20g de solution aqueuse, voire 1g de solide résiduel pour 23g de solution aqueuse.

8. Procédé de récupération d'au moins un métal selon l'une des revendications 1 à 7, dans lequel le traitement hydrothermal selon l'étape b) est réalisé par application d'une chauffe comprise entre 50°C et 400°C pendant 30 min à 4h, de préférence par application d'une chauffe comprise entre 150 et 250°C pendant 1h30 et 2h30 de sorte à atteindre une pression autogène d'environ 20 bars ou par application d'une chauffe entre 350°C et 420°C pendant 1h30 à 2h30 de sorte à atteindre une pression autogène d'environ 290 bars.

9. Procédé de récupération d'au moins un métal selon l'une des revendications 1 à 8, dans lequel le traitement ultrasonore selon l'étape c) comprend l'application d'ondes de fréquence comprise entre 20 et 80 kHz, par exemple entre 30 et 40 kHz et en particulier à 37kHz, notamment à pression atmosphérique, et en particulier sur une durée comprise entre 15 min et 70 min, par exemple entre 20 et 60 min.

[FIG.1]

[FIG.2]

[FIG.3]

[FIG.4]

[FIG.5]

[FIG.6]

[FIG.7]

Europäisches
Patentamt

European
Patent Office

Office européen
des brevets

**RAPPORT DE RECHERCHE EUROPEENNE**

Numéro de la demande

EP 25 22 0920

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | CN 117 463 759 A (UNIV KUNMING SCIENCE & TECHNOLOGY) 30 janvier 2024 (2024-01-30) * revendications; figures; exemples * ----- | 1-9 | INV. B09B3/45 B09B3/50 B29B17/02 |
| Y | WO 2020/240126 A1 (ROSI [FR]) 3 décembre 2020 (2020-12-03) * pages 9,10 * ----- | 1-9 | B32B43/00 C22B1/00 C22B7/00 C22B11/00 |
| Y | CN 118 326 166 A (9TECH LLC) 12 juillet 2024 (2024-07-12) * revendications; figures; exemples * ----- | 1-9 | C22B15/00 C22B21/00 H10F19/80 H10F71/00 |
| A | JP 2014 104406 A (YOKOHAMA YUSHI KOGYO KK) 9 juin 2014 (2014-06-09) * revendications * ----- | 1-9 | C22B3/44 C22B3/02 C22B3/04 |
|  |  |  | ADD. B09B101/15 |

| DOMAINES TECHNIQUES RECHERCHES (IPC) |
|---|
| B09B C22B B29B B32B H10F |

Le présent rapport a été établi pour toutes les revendications

| Lieu de la recherche | Date d'achèvement de la recherche | Examinateur |
|---|---|---|
| Munich | 6 avril 2026 | Tassinari, Francesca |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.................................................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 25 22 0920

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

06-04-2026

| Document brevet cité au rapport de recherche | | Date de publication | Membre(s) de la famille de brevet(s) | | Date de publication |
|---|---|---|---|---|---|
| CN 117463759 | A | 30-01-2024 | AUCUN | | |
| WO 2020240126 | A1 | 03-12-2020 | CN | 114207164 A | 18-03-2022 |
| | | | EP | 3977520 A1 | 06-04-2022 |
| | | | ES | 2946702 T3 | 24-07-2023 |
| | | | FR | 3096833 A1 | 04-12-2020 |
| | | | JP | 7527311 B2 | 02-08-2024 |
| | | | JP | 2022535225 A | 05-08-2022 |
| | | | PT | 3977520 T | 07-06-2023 |
| | | | US | 2022228235 A1 | 21-07-2022 |
| | | | WO | 2020240126 A1 | 03-12-2020 |
| CN 118326166 | A | 12-07-2024 | CN | 118326166 A | 12-07-2024 |
| | | | EP | 4400617 A1 | 17-07-2024 |
| | | | US | 2024229192 A1 | 11-07-2024 |
| JP 2014104406 | A | 09-06-2014 | JP | 6068948 B2 | 25-01-2017 |
| | | | JP | 2014104406 A | 09-06-2014 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 3118902 A
- WO 2020240126 A
- WO 2020104754 A